# EUROPEAN PATENT SPECIFICATION

(11) **EP 3 182 429 B1**
(45) Date of publication and mention of the grant of the patent: **31.10.2018**
(21) Application number: 15200930.4
(22) Date of filing: 17.12.2015
(51) Int. Cl.: H01G 4/28, H01G 4/258, G01R 15/16, H01G 4/20

(54) **CAPACITOR, CAPACITIVE VOLTAGE SENSOR AND METHOD FOR MANUFACTURING A CAPACITOR**
KONDENSATOR, KAPAZITIVER SPANNUNGSSENSOR UND VERFAHREN ZUR HERSTELLUNG EINES KONDENSATORS
CONDENSATEUR, CAPTEUR DE TENSION CAPACITIF ET PROCÉDÉ DE FABRICATION D'UN CONDENSATEUR

(43) Date of publication of application: 21.06.2017
(73) Proprietor: 3M Innovative Properties Company, St. Paul, MN 55133-3427 (US)
(72) Inventor: Stollwerck, Gunther, Dr., 47802 Krefeld (DE); Gravermann, Mark, 41812 Erkelenz (DE); Muggli, Mark, 84547 Emmerting (DE)
(74) Representative: Bergen, Katja

(56) References cited:
- EP-A1- 2 887 074
- US-A- 2 922 865
- US-A- 3 339 130
- US-A1- 2006 258 327
- US-A1- 2007 087 929
- RAJ P M ET AL: "Low Temperature (<<100[deg.]C) deposited pyrochlore films with high capacitance (200 nF/cm2), low loss ( PRG 0.003) and low TCF (<<100 ppm/C) for integrating RF components", 58TH ELECTRONIC COMPONENTS AND TECHNOLOGY CONFERENCE - 27-30 MAY 2008 - LAKE BUENA VISTA, FL, USA, IEEE, PISCATAWAY, NJ, USA, 27 May 2008 (2008-05-27), pages 688-693, XP031276267, ISBN: 978-1-4244-2230-2

## Description

The present invention relates to a capacitor, a capacitive voltage sensor, and a method for manufacturing a capacitor, particularly a capacitor with improved temperature stability of the capacitance value.

Although the invention is explained and discussed in conjunction with a cylindrical capacitor, the principles of the invention may easily be transferred to other types of capacitors as well, for example spherical capacitors or parallel plate capacitors.

Measuring the voltage in high-voltage or medium-voltage conductor assemblies in power networks, such as power cables or bus bars, is a difficult task due to the relatively high voltages and currents involved. Sensors which are based on capacitive voltage dividers have been employed in the past. In such sensors, as for example disclosed in document US 4,963,819 A, a sensing capacitor and a reference circuit element having complex impedance (e.g. a resistor, an inductivity or a further capacitor) are connected in series with their electrical properties determining the dividing ratio of the voltage divider. The sensing capacitor provides for galvanic separation from the power conductor. The voltage drop across the reference circuit element is then generally proportional to the voltage level of the power conductor.

Some of the contemporary capacitive voltage sensors include a high module ethylene propylene rubber (HEPR) insulation dielectric with a flexible outer electrode mounted thereon. However, the dielectric material can on one hand expand freely with temperature, thereby causing the capacitance value of the sensing capacitor to vastly decrease with rising temperature. On the other hand, conventional dielectric materials may have an inherent negative thermal gradient of their relative permittivity, i.e. the capacitance value of the sensing capacitor decreases with rising temperature due to a decreasing relative permittivity of the dielectric material.

There have been several attempts to remedy the fluctuations of the capacitance value of the sensing capacitor of a capacitive voltage sensor and their negative impact on measuring accuracy and reliability. For example, the fluctuations of the capacitance value may be compensated for through the use of a compensating element in the measurement circuitry, such as for example an NTC thermistor. Document US 4,241,373 A for example discloses the use of a switchgear voltage sensor, a thermistor and a resistor in a compensating network to compensate for temperature induced changes in the dielectric properties of a cast epoxy of a sensing capacitor. Document US 2014/0021965 A1 discloses temperature compensation techniques in an apparatus for measuring the potential on a shielded high-voltage cable in medium-voltage distribution networks. Document EP 2 508 898 A1 discloses a capacitive sensor arrangement on a cable employing temperature correction techniques through direct measurement of the sensor temperature and appropriate measurement signal correction or addition of a temperature-dependent element correcting temperature induced deviations in the measurement signal.

Other attempts involve capacitive medium voltage sensors including ceramic dielectrics or dielectric materials with ceramic filler particles. For example, document US 2006/0258327 A1 discloses a compensation method for compensating the thermal gradient of permittivity of a polymeric matrix with ceramic fillers having opposite thermal gradients of permittivity. Document EP 1 017 069 A2 discloses temperature compensating capacitors and dielectric ceramic powder compositions based upon a dual-component barium borate and zinc silicate sintering flux.

Further suggestions for temperature compensated capacitive voltage sensors rely on integrated reference capacitors that are subject to the same or at least similar temperature deviations of capacitance values as the sensing capacitors. For example, document WO 01/94956 A1 discloses voltage monitoring arrangements for electrical switchgear that includes a sandwich structure of a sensing electrode and a screening electrode that are spaced apart by insulating material having substantially the same temperature coefficient of relative permittivity as the insulating body of the power conductor in the electrical switchgear.

US 3,309,130 discloses a capacitor means with a dielectric portion. The dielectric portion comprises a composition of material as disclosed in US 2,922,865, which is a material consisting essentially of from about 60 % to 90 % barium titanate and the reminder a binder of heat-resistant organic polymer.

There is, however, a need for improved solutions for compensation of temperature induced deviations of the capacitance value of voltage sensing capacitors.

This need is met by a capacitor having the features of claim 1, a capacitive voltage sensor having the features of claim 7, and a method for manufacturing a capacitor having the features of claim 8.

A first aspect of the disclosure pertains to a capacitor as defined in claim 1, comprising an electrically conductive cylinder, an electrically conductive or semi-conductive cylindrical shell or shell segment arranged concentrically around the electrically conductive cylinder, and a dielectric arranged between the electrically conductive cylinder and the electrically conductive or semi-conductive cylindrical shell or shell segment. The dielectric comprises a particulate composite including a matrix material having a negative thermal coefficient of relative permittivity and a particulate filler material blended with the matrix material, the particulate filler material having a positive. thermal coefficient of relative permittivity.

The positive thermal coefficient of relative permittivity is thereby selected such that the capacitance value of the capacitor is constant within a stability margin over a predefined temperature interval.

The stability margin of the capacitor according to the invention may for example be equal to or less than +/-3.0%, +/-0.5% or +/-0.2% of the capacitance value of the capacitor according to IEC 60044-7 (1999). The predefined temperature interval is according to IEC 60044-7 (1999) between -25°C and +40°C or between -40°C and +40°C. Depending on the desired application of the capacitor, other predefined temperature intervals may be chosen as well, such as between -20°C and +60°C, or between -40°C and +70°C.

According to a second aspect of the disclosure, a capacitive voltage as defined in claim 7 comprises a capacitor according to the first aspect of the disclosure as voltage sensing capacitor, a reference impedance coupled in series between the voltage sensing capacitor and a reference potential, and a voltage measurement circuit configured to measure a voltage drop across the reference impedance. The voltage sensing capacitor and the reference impedance may in particular implement a voltage divider circuit with a predefined dividing ratio. The voltage measurement circuit may for example comprise a voltage measurement device or an operational amplifier circuit or a remote terminal unit, which is measuring the voltage.

According to a third aspect of the disclosure, claim 8 defines a method for manufacturing a capacitor according to the first aspect of the disclosure for use in a capacitive voltage sensor according to the second aspect of the disclosure, which comprises the steps of applying a dielectric to an electrically conductive cylinder, and arranging an electrically conductive or semi-conductive cylindrical shell or shell segment concentrically around the electrically conductive cylinder over the dielectric. The dielectric comprises a particulate composite including a matrix material having a negative thermal coefficient of relative permittivity and a particulate filler material blended with the matrix material, the particulate filler material having a positive thermal coefficient of relative permittivity.

One of the ideas on which the present invention is based is to use a composite material of dielectric materials in a voltage sensing capacitor with the thermal gradient of relative permittivity of a filler material used in the dielectric (a compensation filler) being chosen in such a way that any changes in relative permittivity of the matrix material with temperature and any changes in capacitance value of the voltage sensing capacitor due to thermal expansion of the components are both compensated for.

Without the compensation filler, the thermal coefficient of the capacitance value of the voltage sensing capacitor is typically negative, i.e. the capacitance value decreases with increasing temperature with typically and preferably chosen dielectrics. Thus, the material of the compensation filler may preferably be chosen to have a positive thermal coefficient of relative permittivity, i.e. the relative permittivity of the compensation filler increases with increasing temperature.

Advantageously, the need for an external electrical compensation technique, such as the use of an NTC thermistor, may be obviated due to the excellent temperature stability of the capacitance value of the voltage sensing capacitor according to the invention. Furthermore, there is advantageously no need for the use of ceramic materials in the dielectric of the voltage sensing capacitor, which are usually quit expensive and difficult to manufacture.

Finally, the manufacturing complexity for voltage sensing capacitors in line with this disclosure is significantly less than for capacitors with comparable thermal stability since they can be produced with standard injection moulding systems by adding particulate filler material into a matrix material, the particulate filler material having an opposite thermal coefficient of relative permittivity as the matrix material.

According to the invention, the matrix material comprises a rubber material, for example a silicone rubber or silicone elastomer, e.g. ethylene propylene diene monomer rubber (EPDM) or high module ethylene propylene rubber (HEPR). In some particular embodiments, the matrix material may comprise one or a combination of liquid silicone, rubber or gumstock rubber. This advantageously allows the use of materials that are readily usable in standard injection moulding systems and are thus producible at low costs.

According to the invention, the particulate filler material comprise one or a combination of an epoxy, a polyurethane resin, polyvinylidenefluoride and polyvinylidenefluoride co-polymers. Those materials may be pulverized and blended with the matrix material to obtain a flexibly adjustable relative permittivity of the particulate composite.

The absolute value of the thermal coefficient of relative permittivity of the filler may be larger than the absolute value of the thermal coefficient of relative permittivity of the matrix, so that the amount of filler may be selected lower than the amount of the matrix needed for the compensation of the thermal gradient of the relative permittivity of the dielectric material. Preferred is that the gradient of the relative permittivity of the filler is three times larger than the according gradient of the matrix, more preferred it that it is five times larger and even more preferred is that it is 10 times larger than the gradient of the matrix. The amount of the filler needed to successfully compensate the temperature dependency of the dielectric depends on the gradient of the filler.

According to some embodiments of the capacitor, the particulate filler material may be included in an amount in the range between 0vol% and 30vol%, e.g. between 0vol% and 20,5vol% particulate filler material. The amount of particulate filler material may advantageously be varied according to the desired compensation properties. If one filler compensates the thermal coefficient of relative permittivity of the matrix only in a limited temperature range, it may be added a second filler that compensates the thermal coefficient of relative permittivity of the matrix in another temperature range. Depending on the material used for the fillers different ranges are possible, e.g. for polyurethane fillers the range may be between 2vol% and 10vol%, for epoxy the range may be between 1vol% and 10vol% and or polyvinylidenefluoride it may be between 5vol% and 30vol%.

According to some embodiments of the capacitor, the electrically conductive cylinder may form part of a high-voltage or medium-voltage power conductor in a high-voltage or medium-voltage power network. The components of the capacitor may in particular be heated up due to the current flowing through current carrying conductors such networks. Due to the large changes of temperature the materials depending on the amount of current flowing through the current carrying conductors of high-voltage or medium-voltage power network the fluctuations in dimensions and relative permittivity of the conventional parts of the capacitor are subject to large changes as well. Therefore, the dielectric according to the invention may be particularly useful for high-voltage of medium-voltage applications.

According to some embodiments of the capacitor, the electrically conductive or semi-conductive cylindrical shell or shell segment comprises a mechanically rigid metal component, in particular an aluminium, steel and/or copper annulus. The mechanically rigid metal component may reduce the thermal expansion effect of the capacitor significantly.

According to some embodiments of the capacitor, the electrically conductive cylindrical or semi-conductive shell or shell segment may comprise a flexible member, in particular a conductive silicone pad or a silicone tube covered with an electrically conductive ink or coating. Such flexible members allow for larger fluctuations of the capacitance values due to thermal expansion, however, with the use of a higher volume percentage of particulate filler materials those fluctuations due to thermal expansion may be advantageously compensated for.

According to an embodiment of the capacitive voltage sensor, parts of the circuitry, and in particular the reference impedance, may be installed on a printed circuit board (PCB). The electrical connection between the reference impedance on the PCB and the voltage sensing capacitor may be established for example by wiring to create a series connection of the voltage sensing capacitor and the reference impedance on the PCB to be used as a voltage divider.

According to some embodiments, the voltage sensing capacitor may extend wholly or only partially around the circumference of the electrically conductive cylinder. For only partially extending capacitors, i.e. capacitors with only a partial shell segment acting as electrically conductive outer electrode, it may be necessary to take additional measures for keeping the outer electrode in place relatively to the electrically conductive cylinder and for shielding the capacitor from interfering electric fields.

The capacitive voltage sensor may be integrated into cable accessory, such as for example a termination, a splice, a separable connector or a t-body, thereby arranging all elements of the sensor in a space saving and compact assembly. The capacitive voltage sensor may further comprise two or more conductive or semi-conductive shells or shell segments that may be brought into engagement with each other in order to form a voltage sensor having tubular shape. This may allow the capacitive voltage sensor to be installed around a current carrying conductor at a longer distance from an end of the current carrying conductor. The capacitive voltage sensor may alternatively have the electrically conductive or semi-conductive shell integrally formed in one piece only for mounting over an end of a cable.

According to another embodiment or the capacitor, a contact element may serve as electrically conductive cylinder. To that end, the contact element may be arranged between a current carrying conductor running through the centre of the capacitor and the dielectric. The contact element may then be electrically connected with the current carrying conductor. This can either be done with the electrically conductive cylinder being a separate electrode element and directly contacting the current carrying conductor. Alternatively, an additional contact element may be arranged between the current carrying conductor and the electrically conductive cylinder which in both cases may be hollow to at least partially surround the contact element and the current carrying conductor.

Providing an additional contact element between the conductor and the electrically conductive cylinder may provide advantageous due to the thermal decoupling of the electrically conductive cylinder from the current carrying conductor. The capacitor may in this case have a lower temperature dependency in terms of thermal expansion, thereby guaranteeing a higher accuracy.

The contact element is ideally mechanically reliable and should withstand mechanical forces caused by relative movement of the capacitor with respect to the current carrying conductor or by different thermal expansion coefficients of the electrically conductive cylinder and the current carrying conductor. The contact element may to this end comprise a resilient portion guaranteeing a reliable and therefore low resistance contact surface between the current carrying conductor and the electrically conductive cylinder. The contact element may be resiliently supported and/or consist of resilient material. The contact element may for example comprise elastomeric material which may be electrically conductive or be coated with an electrically conductive surface coating.

The invention will be explained in greater detail with reference to exemplary embodiments depicted in the drawings as appended.

The accompanying drawings are included to provide a further understanding of the present invention and are incorporated in and constitute a part of this specification. The drawings illustrate the embodiments of the present invention and together with the description serve to explain the principles of the invention. Other embodiments of the present invention and many of the intended advantages of the present invention will be readily appreciated as they become better understood by reference to the following detailed description. The elements of the drawings are not necessarily to scale relative to each other. Like reference numerals designate corresponding similar parts.
- Fig. 1: schematically illustrates a perspective view of a voltage sensing capacitor according to an embodiment of the invention.
- Fig. 2: schematically illustrates an axial cross section view through the voltage sensing capacitor of Fig. 1 along the line A-A according to a further embodiment of the invention.
- Fig. 3: schematically illustrates a radial cross section view through the voltage sensing capacitor of Fig. 1 along the line B-B according to a further embodiment of the invention.
- Fig. 4: schematically illustrates a radial cross section view through a modified voltage sensing capacitor according to another embodiment of the invention.
- Fig. 5: schematically illustrates a radial cross section view through a modified voltage sensing capacitor according to an even further embodiment of the invention.
- Fig. 6: shows a measurement diagram illustrating the thermal dependence of capacitance value of a voltage sensing capacitor according to a further embodiment of the invention.
- Fig. 7: shows a measurement diagram illustrating the thermal dependence of capacitance value of a further voltage sensing capacitor according to yet another embodiment of the invention.
- Fig. 8: schematically illustrates a block diagram of capacitive voltage sensor circuitry according to another embodiment of the invention.
- Fig. 9: schematically illustrates stages of a method for manufacturing a voltage sensing capacitor according to another embodiment of the invention.

In the figures, like reference numerals denote like or functionally like components, unless indicated otherwise. Any directional terminology like "top", "bottom", "left", "right", "above", "below", "horizontal", "vertical", "back", "front", and similar terms are merely used for explanatory purposes and are not intended to delimit the embodiments to the specific arrangements as shown in the drawings.

Although specific embodiments have been illustrated and described herein, it will be appreciated by those of ordinary skill in the art that a variety of alternate and/or equivalent implementations may be substituted for the specific embodiments shown and described without departing from the scope of the present invention. Generally, this application is intended to cover any adaptations or variations of the specific embodiments discussed herein.

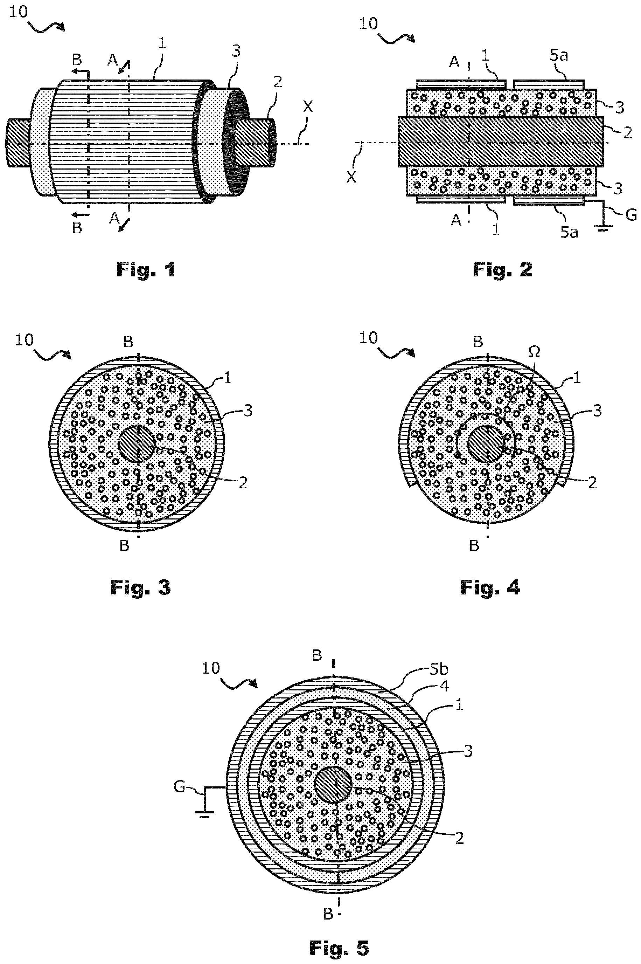

A perspective view of a voltage sensing capacitor 10 is schematically illustrated in Fig. 1. The two sectional view along the lines A-A and B-B of the voltage sensing capacitor 10 of Fig. 1 are shown in Figs. 2 and 3, respectively. The voltage sensing capacitor 10 is generally of cylindrical or tubular shape having a central axis denoted with the reference sign X. Of course, the cylindrical shape does not necessarily need to be straight, but instead bent or curved cylindrical shapes may be equally possible. Particularly, when used for sensing a voltage of a current carrying conductor, the voltage sensing capacitor 10 may be manufactured from generally flexible or elastic materials, allowing the capacitor 10 to be bent at its central axis X to deviate from the purely straight cylindrical shape.

Along the central axis X an electrically conductive cylinder 2 is arranged to act as an inner electrode of the capacitor 10. The electrically conductive cylinder 2 may particularly form a part of a high-voltage or medium-voltage power conductor in a high-voltage or medium-voltage power network. An electrically conductive or semi-conductive cylindrical shell 1 is arranged concentrically around the electrically conductive cylinder 2, being spaced apart from the electrically conductive cylinder 2. The electrically conductive or semi-conductive cylindrical shell 1 acts as outer electrode or counter-electrode for the inner electrode of the capacitor 10. In between the two electrodes 1 and 2, a dielectric 3 is arranged.

As can be seen in the drawings of Figs. 2 and 3, the dielectric 3 generally includes a particulate composite. The particulate composite is comprised of a matrix material having a negative thermal coefficient of relative permittivity and a particulate filler material blended with the matrix material, the particulate filler material having a positive thermal coefficient of relative permittivity. Therefore, upon an increase in temperature, the change in relative permittivity of the matrix material will be offset by the opposite change in relative permittivity of the particulate filler material.

The filler material is therefore chosen to have a positive thermal coefficient of relative permittivity, and it comprises one or a combination of an epoxy such as Scotchcast® Electrical Resin 8, a polyurethane resin such as Scotchcast® Electrical Insulating Resin 40 or Scotchcast® Electrical Insulating Resin 1402 FR, all available from 3M Company, U.S.A., polyvinylidenefluoride and polyvinylidenefluoride co-polymers such as Dyneon® PVDF 31508 or Dyneon® PVDF 11008, both available from 3M Company, U.S.A. The positive thermal coefficient of relative permittivity of the filler material is selected such that the capacitance value of the capacitor is constant within a stability margin over a predefined temperature interval. In other words, the positive thermal coefficient of relative permittivity of the filler material is used to compensate for the negative thermal coefficient of relative permittivity of the matrix material so that the effective relative permittivity of the dielectric 3 as a whole will remain stable with a change in temperature or will slightly increase within a predefined temperature interval. The desired effective relative permittivity may be adjusted by selecting appropriate filler material and by varying the amount of filler material in the particulate composite.

The stability margin may be predefined according to quality standards of the voltage sensing capacitor when used in a capacitive voltage sensor. Some quality standards like IEC 60044-7 (1999) define a stability margin equal to or less than +/-3.0% or +/-0.5% or +/-0.2% of the capacitance value of the capacitor 10. The material, dimensions and positioning of the filler material and the matrix material may thus be selected to be able to keep the capacitance value within the desired stability margin.

The predefined temperature interval is according to IEC 60044-7 (1999) between -25°C and +40°C or between -40°C and +40°C. Depending on the desired application of the capacitor, other predefined temperature intervals may be chosen as well, such as between -20°C and +60°C, or between -40°C and +70°C.

Figs. 4 and 5 each schematically illustrate modified voltage sensing capacitors 10 in radial cross section view similar to the view in Fig. 3. The voltage sensing capacitors 10 of the Figs. 4 and 5 are each modified in different details and various features with respect to the voltage sensing capacitor 10 as shown and explained in conjunction with Figs. 1, 2 and 3. Of course, the modification of the details for one of the voltage sensing capacitors 10 of the Figs. 4 and 5 may equally be applied to respective other ones of the voltage sensing capacitors 10 and the modification possibilities are not limited to the ones explicitly and exemplarily depicted in those drawings.

The outer electrode in Figs. 2 and 3 is depicted as closed ring structure, i.e. a shell 1 surrounding the full 360° of the circumference of the cylindrical capacitor shape. However, as exemplarily depicted in Fig. 4, it may be equally possible to use an electrically conductive or semi-conductive cylindrical shell segment 1 that only surrounds a fraction Ω of the circumference of the cylindrical capacitor shape. The fraction Ω may be chosen according to the intended application and may generally take on any value between 0° and 360°. It may further be possible to use more than one electrically conductive or semi-conductive cylindrical shell segment 1 as outer electrode so that a plurality of electrically conductive or semi-conductive cylindrical shell segments 1 may be equidistantly spaced around the circumference of the cylindrical capacitor shape.

As shown in Fig. 5, it may be possible to provide a screening electrode 5b arranged concentrically with and around the electrically conductive or semi-conductive cylindrical shell 1. The screening electrode 5b may be connected to a reference potential, for example to ground G. A further dielectric 4, for example being made of the same material as the dielectric 3 may be provided between the electrically conductive cylindrical or semi-conductive shell 1 and the screening electrode 5b. The capacitor formed by the electrically conductive cylindrical or semi-conductive shell 1 as inner electrode, the dielectric 4 and the screening electrode 5b may also be used as reference capacitor in a series connection with the screened voltage sensing capacitor 10. That way, some of the thermal expansion effects affecting the screened voltage sensing capacitor 10 may apply equally to the reference capacitor as well, so that the dividing ratio of the voltage divider is kept approximately constant.

If the electrically conductive or semi-conductive cylindrical shell 1 or shell segment comprises a mechanically rigid metal component, for example an aluminium, steel and/or copper annulus, the dielectric 3 may at least partly be implemented as embedded dielectric in the inner wall of the rigid metal component.

The electrically conductive or semi-conductive cylindrical shell 1 may be shaped in ring form having a recessed trench extending circumferentially in its inner wall (not shown in the drawings). The dielectric 3 may then be at least partially implemented as mastic or sealant that is embedded within the recessed trench of the electrically conductive cylindrical shell 1 or shell segment.

Fig. 2 further shows the implementation of a laterally shifted grounding electrode 5a placed near the electrically conductive cylindrical or semi-conductive shell 1 or shell segment. The laterally shifted grounding electrode 5a of Fig. 2 may be connected to a reference potential, such as ground G.

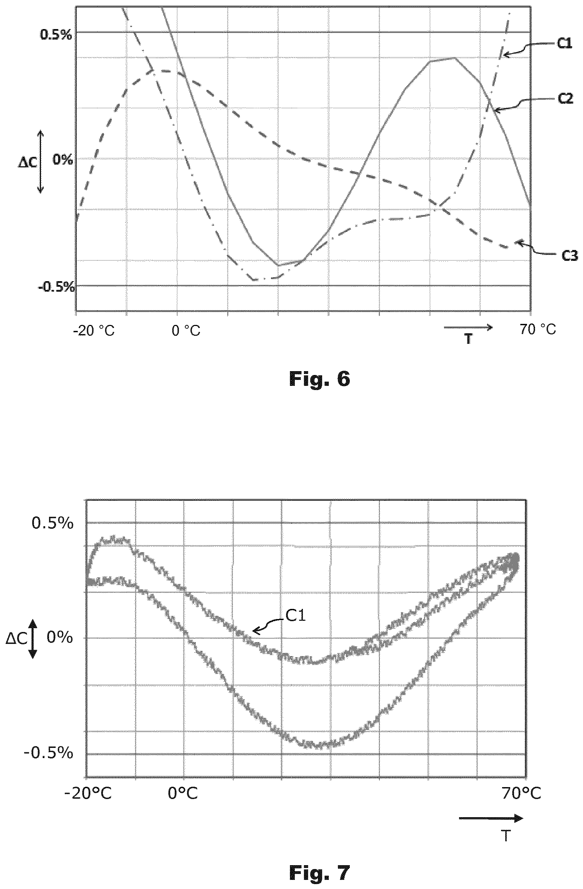

Fig. 6 shows a measurement diagram illustrating the thermal dependence C1, C2, C3 of capacitance value C of a voltage sensing capacitor 10 for various combinations of materials of the matrix and the filler. The measurement curve C1 depicts the capacitance value C vs temperature for an Elastosil® LR 3003/70 silicone as matrix loaded with 1.8 vol% of Scotchcast® Electrical Resin 8 epoxy as particulate filler material. The measurement curve C2 depicts the capacitance value C vs temperature for an Elastosil® LR 3003/70 silicone as matrix loaded with 8 vol% of Scotchcast® Electrical Resin 2160 polyurethane as particulate filler material. The measurement curve C3 depicts the capacitance value C vs temperature for an Elastosil® LR 3003/70 silicone as matrix loaded with 18 vol% of Dyneon® PVDF 31508 as particulate filler material.

As can be seen, the composite material used as dielectric 3 compensates the oppositely changing relative permittivities with temperature of both matrix and filler material over a large temperature interval. As can be seen, the relative deviation ΔC from a reference capacitance value for the curve C1 does not exceed ±0.5% over a temperature interval of at least -5°C to +65°C, C2 does not exceed ±0.5% over a temperature interval of at least 0°C to +70°C, C3 does not exceed ±0.5% over a temperature interval of at least -20°C to +70°C.

Fig. 7 shows a measurement diagram illustrating the thermal dependence C1 of capacitance value C of a voltage sensing capacitor 10 including Elastosil® LR3003/70 silicone as matrix material loaded with 8.5vol% of Dyneon® PVDF 11008 as particulate filler material. As can be seen, the relative deviation ΔC from a reference capacitance value for this combination does not exceed ±0.5% over a temperature interval of at least -20°C to +70°C.

Typical axial lengths of the cylindrical capacitors 10 are at least 20mm to 500mm, preferably between 30mm to 60mm. Any other length is possible as well and strongly depends on the application. In particular, matrix materials having high shore hardness may be advantageously chosen to largely avoid thermal expansion problems.

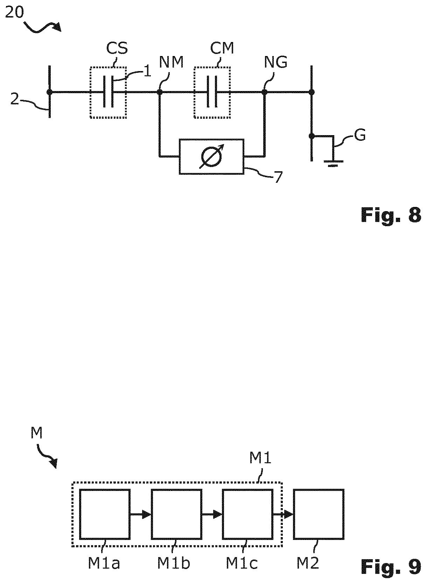

Fig. 8 schematically illustrates a block diagram of capacitive voltage sensor circuitry 20 employing a capacitor 10 as a voltage sensing capacitor CS of a voltage divider. A reference impedance, such as for example a reference capacitor CM, is coupled in series between the voltage sensing capacitor CS and a reference potential such as for example ground G. A voltage measurement circuit 7 that is connected to a node NM between the two capacitors CS and CM on one hand and to a node NG connected to the reference potential on the other hand is configured to measure a voltage drop across the reference capacitor CM. The measured voltage drop may then be output to a control processor 8 that produces a corresponding voltage signal. The control processor 8 may for example be additionally equipped with electronic compensation means that further enhance the accuracy of the voltage signal, for example by taking into account temperature induced variations of the electric properties of the capacitors CS and CM. The reference capacitor CM may for example be installed on a PCB in the vicinity of the voltage sensing capacitor CS to provide for a compact voltage sensor assembly 20.

Fig. 9 schematically illustrates stages of a method M for manufacturing a capacitor, for example a voltage sensing capacitor 10 as explained in conjunction with Figs. 1 to 5. The method M may be specifically used for manufacturing a capacitor that may be used as voltage sensing capacitor CS in a capacitive voltage sensor assembly 20 as illustrated in conjunction with Fig. 8.

In a first stage M1, a dielectric 3 is applied to an electrically conductive cylinder 2. The dielectric 3 is comprised of a particulate composite including a matrix material having a negative thermal coefficient of relative permittivity and a particulate filler material blended with the matrix material, the particulate filler material having a positive thermal coefficient of relative permittivity. The application in stage M1 may for example be performed by mixing the particulate material to the liquid silicone rubber or liquid silicone elastomer composition in a static or dynamic mixer of an injection moulding machine in a substage M1b. In order to mix the particulate filler material into the matrix material, the filler material should be pulverized to a powder as fine as possible. Such pulverization may be performed using a granular mill to obtain sub-millimeter particulate powder.

Typically, injection moulding machines may only allow for a maximum amount of 5vol% of particulate material to be added in the mixer section due to restraints in the pumpability of the silicone oil component of the liquid silicone rubber or liquid silicone elastomer composition. If a higher amount of particulate material in the composite is desired, a previous optional substage M1a may be performed in which additional particulate material is blended with the liquid silicone rubber or liquid silicone elastomer composition prior to filling the composition into the injection moulding machine. The mixed silicone composition is then injection moulded in substage M1c over the electrically conductive cylinder 2. In a further option the electrically conductive or semi-conductive cylindrical shell 1 or shell segment in form of a mechanically rigid metal component may be inserted in the injection mold, so that the dielectric 3 fills the volume between cylinder 2 and conductive or semi-conductive cylindrical shell 1 or shell segment in one step. Step M2 can be omitted in this situation.

Then, in a stage M2, an electrically conductive cylindrical or semi-conductive shell 1 or shell segment is arranged concentrically around the electrically conductive cylinder 2 over the dielectric 3. This may for example be done by applying an electrically conductive ink or coating on the dielectric 3, or, alternatively, providing a flexible member such as an electrically conductive silicone pad or tube on the dielectric 3. For electrically contacting the electrically conductive cylindrical shell 1 or shell segment a copper tape may be applied on top of the electrode.

In the foregoing detailed description, various features are grouped together in one or more examples or examples with the purpose of streamlining the disclosure. It is to be understood that the above description is intended to be illustrative, and not restrictive. It is intended to cover all alternatives, modifications and equivalents. Many other examples will be apparent to one skilled in the art upon reviewing the above specification.

The embodiments were chosen and described in order to best explain the principles of the invention and its practical applications, to thereby enable others skilled in the art to best utilize the invention and various embodiments with various modifications as are suited to the particular use contemplated. In the appended claims and throughout the specification, the terms "including" and "in which" are used as the plain-English equivalents of the respective terms "comprising" and "wherein," respectively. Furthermore, "a" or "one" does not exclude a plurality in the present case.

## Claims

1. Capacitor (10), comprising:
an electrically conductive cylinder (2);
an electrically conductive or semi-conductive cylindrical shell (1) or shell segment arranged concentrically around the electrically conductive cylinder (2); and
a dielectric (3) arranged between the electrically conductive cylinder (2) and the electrically conductive or semi-conductive cylindrical shell (1) or shell segment,
the dielectric (3) comprising:
a particulate composite including a matrix material having a negative thermal coefficient of relative permittivity and a particulate filler material blended with the matrix material, the particulate filler material having a positive thermal coefficient of relative permittivity,
**characterized in that** the matrix material comprises a rubber material, such as silicone rubber or a silicone elastomer and wherein the particulate filler material comprises one or a combination of an epoxy, a polyurethane resin,
polyvinylidenefluoride and polyvinylidenefluoride co-polymers.

2. Capacitor (10) according to claim 1 , wherein the matrix material comprises one or a combination of ethylene propylene diene monomer (EPDM) and high module ethylene propylene rubber (HEPR).

3. Capacitor (10) according to claim 1 or 2, wherein the particulate filler material is included in the matrix material in an amount between 0vol% and 30vol% of particulate filler material.

4. Capacitor (10) according to one of the claims 1 to 3, wherein the electrically conductive cylinder (2) forms part of a high-voltage or medium-voltage power conductor in a high-voltage or medium-voltage power network.

5. Capacitor (10) according to one of the claims 1 to 4, wherein the electrically conductive or semi-conductive cylindrical shell (1) or shell segment comprises a mechanically rigid metal component, in particular an aluminium, steel and/or copper annulus.

6. Capacitor (10) according to one of the claims 1 to 4, wherein the electrically conductive or semi-conductive cylindrical shell (1) or shell segment comprises a flexible member, in particular a conductive silicone tube or a silicone pad covered with an electrically conductive ink or coating.

7. Capacitive voltage sensor (20), comprising:
a capacitor (10) according to one of the claims 1 to 6 as voltage sensing capacitor (CS);
a reference impedance (CM) coupled in series between the voltage sensing capacitor (CS) and a reference potential (G); and
a voltage measurement circuit configured to measure a voltage drop across the reference impedance (CM).

8. Method (M) for manufacturing a capacitor (10) according to any of the claims 1 to 6, comprising the steps of:
- applying (M1) a dielectric (3) to an electrically conductive cylinder (2); and
- arranging (M2) an electrically conductive or semi-conductive cylindrical shell (1) or shell segment concentrically around the electrically conductive cylinder (2) over the dielectric (3),
wherein the dielectric (3) comprises a particulate composite including a matrix material having a negative thermal coefficient of relative permittivity and a particulate filler material blended with the matrix material, the particulate filler material having a positive thermal coefficient of relative permittivity, **characterized in that** the matrix material comprises a rubber material, such as silicone rubber or a silicone elastomer and wherein the particulate filler material comprises one or a combination of an epoxy, a polyurethane resin, polyvinylidenefluoride and polyvinylidenefluoride co-polymers.

9. Method (M) according to claim 8, wherein applying (M1) the dielectric (3) comprises:
- mixing (M1b) the particulate filler material to the liquid silicone rubber or silicone elastomer composition in a static or dynamic mixer of an injection moulding machine; and
- injection moulding (M1c) the mixed silicone composition over the electrically conductive cylinder (2).

10. Method (M) according to claim 9, further comprising:
blending (M1a) additional particulate filler material with the liquid silicone rubber or
silicone elastomer composition prior to filling the composition into the injection moulding machine.

## Patentansprüche

1. Kondensator (10), umfassend:
einen elektrisch leitenden Zylinder (2);
eine konzentrisch um den elektrisch leitenden Zylinder (2) angeordnete elektrisch leitende oder halbleitende zylindrische Schale (1) oder ein Schalensegment; und ein zwischen dem elektrisch leitenden Zylinder (2) und der elektrisch leitenden oder halbleitenden zylindrischen Schale (1) oder dem Schalensegment angeordnetes Dielektrikum (3), wobei das Dielektrikum (3) umfasst:
ein partikelförmiges Verbundmaterial, das ein Matrixmaterial enthält, das einen negativen Wärmekoeffizienten der relativen Dielektrizitätskonstanten aufweist, und ein partikelförmiges Füllmaterial, das mit dem Matrixmaterial gemischt ist, wobei das partikelförmige Füllmaterial einen positiven Wärmekoeffizienten der relativen Dielektrizitätskonstanten aufweist,
**dadurch gekennzeichnet, dass** das Matrixmaterial ein Kautschukmaterial wie z. B. Silikonkautschuk oder ein Silikonelastomer umfasst und wobei das partikelförmige Füllmaterial eines von oder eine Kombination aus einem Epoxid, einem Polyurethanharz, Polyvinylidenfluorid und Polyvinylidenfluoridcopolymeren umfasst.

2. Kondensator (10) nach Anspruch 1, wobei das Matrixmaterial eines von oder eine Kombination aus Ethylenpropylendienmonomer (EPDM) und Ethylenpropylenkautschuk mit hohem Modul (HEPR) umfasst.

3. Kondensator (10) nach Anspruch 1 oder 2, wobei das partikelförmige Füllmaterial in dem Matrixmaterial in einer Menge zwischen 0 Vol.-% und 30 Vol.-% partikelförmigem Füllmaterial enthalten ist.

4. Kondensator (10) nach einem der Ansprüche 1 bis 3, wobei der elektrisch leitende Zylinder (2) Teil eines Hochspannungs- oder Mittelspannungsleiters in einem Hochspannungs- oder Mittelspannungsnetz ist.

5. Kondensator (10) nach einem der Ansprüche 1 bis 4, wobei die elektrisch leitende oder halbleitende zylindrische Schale (1) oder das Schalensegment einen mechanisch starren Metallbestandteil umfasst, insbesondere einen Aluminium-, Stahl- und/oder Kupferring.

6. Kondensator (10) nach einem der Ansprüche 1 bis 4, wobei die elektrisch leitende oder halbleitende zylindrische Schale (1) oder das Schalensegment ein flexibles Element umfasst, insbesondere einen leitenden Silikonschlauch oder ein mit einer elektrisch leitenden Tinte oder Beschichtung bedecktes Silikonpad.

7. Kapazitiver Spannungssensor (20), umfassend:
einen Kondensator (10) nach einem der Ansprüche 1 bis 6 als Spannungserfassungskondensator (CS);
eine Referenzimpedanz (CM), die in Reihe zwischen den Spannungserfassungskondensator (CS) und ein Referenzpotenzial (G) geschaltet ist; und
eine Spannungsmessschaltung, die konfiguriert ist, um einen Spannungsabfall an der Referenzimpedanz (CM) zu messen.

8. Verfahren (M) zum Herstellen eines Kondensators (10) nach einem der Ansprüche 1 bis 6, das die Schritte umfasst:
- Aufbringen (M1) eines Dielektrikums (3) auf einen elektrisch leitenden Zylinder (2); und
- Anordnen (M2) einer elektrisch leitenden oder halbleitenden zylindrischen Schale (1) oder eines Schalensegments konzentrisch um den elektrisch leitenden Zylinder (2) über dem Dielektrikum (3),
wobei das Dielektrikum (3) ein partikelförmiges Verbundmaterial, das ein Matrixmaterial enthält, das einen negativen Wärmekoeffizienten der relativen Dielektrizitätskonstanten aufweist, und ein partikelförmiges Füllmaterial umfasst, das mit dem Matrixmaterial gemischt ist, wobei das partikelförmige Füllmaterial einen positiven Wärmekoeffizienten der relativen Dielektrizitätskonstanten aufweist, **dadurch gekennzeichnet, dass** das Matrixmaterial ein Kautschukmaterial wie z. B. Silikonkautschuk oder ein Silikonelastomer umfasst und wobei das partikelförmige Füllmaterial eines von oder eine Kombination aus einem Epoxid, einem Polyurethanharz, Polyvinylidenfluorid und Polyvinylidenfluoridcopolymeren umfasst.

9. Verfahren (M) nach Anspruch 8, wobei das Aufbringen (M1) des Dielektrikums (3) umfasst:
- Mischen (M1b) des partikelförmigen Füllmaterials mit der flüssigen Silikonkautschuk- oder Silikonelastomerzusammensetzung in einem statischen oder dynamischen Mischer einer Spritzgießmaschine; und
- Spritzgießen (M1c) der gemischten Silikonzusammensetzung über dem elektrisch leitenden Zylinder (2).

10. Verfahren (M) nach Anspruch 9, ferner umfassend:
Mischen (M1a) von weiterem partikelförmigen Füllmaterial mit der flüssigen Silikonkautschuk- oder Silikonelastomerzusammensetzung vor dem Füllen der Zusammensetzung in die Spritzgießmaschine.

## Revendications

1. Condensateur (10), comprenant :
un cylindre électriquement conducteur (2) ;
une enveloppe cylindrique électriquement conductrice ou semi-conductrice (1) ou un segment d'enveloppe agencé de manière concentrique autour du cylindre électriquement conducteur (2) ; et un diélectrique (3) agencé entre le cylindre électriquement conducteur (2) et l'enveloppe cylindrique électriquement conductrice ou semi-conductrice (1) ou le segment d'enveloppe, le diélectrique (3) comprenant :
un composite particulaire incluant un matériau de matrice ayant un coefficient thermique de permittivité relative négatif et un matériau de charge particulaire mélangé au matériau de matrice, le matériau de charge particulaire ayant un coefficient thermique de permittivité relative positif,
**caractérisé en ce que** le matériau de matrice comprend un matériau de caoutchouc, tel qu'un caoutchouc de silicone ou un élastomère de silicone et dans lequel le matériau de charge particulaire comprend un ou une combinaison d'un époxy, d'une résine polyuréthane, de fluorure de polyvinylidène et de copolymères de fluorure de polyvinylidène.

2. Condensateur (10) selon la revendication 1, dans lequel le matériau de matrice comprend un ou une combinaison de monomère d'éthylène-propylènediène (EPDM) et de caoutchouc d'éthylène-propylène à haut module (HEPR).

3. Condensateur (10) selon la revendication 1 ou 2, dans lequel le matériau de charge particulaire est inclus dans le matériau de matrice en une quantité comprise entre 0 % en volume et 30 % en volume du matériau de charge particulaire.

4. Condensateur (10) selon l'une des revendications 1 à 3, dans lequel le cylindre électriquement conducteur (2) fait partie d'un conducteur d'alimentation à haute tension ou moyenne tension dans un réseau électrique à haute tension ou moyenne tension.

5. Condensateur (10) selon l'une des revendications 1 à 4, dans lequel l'enveloppe cylindrique électriquement conductrice ou semi-conductrice (1) ou le segment d'enveloppe comprend un composant métallique mécaniquement rigide, en particulier, un anneau en aluminium, acier et/ou cuivre.

6. Condensateur (10) selon l'une des revendications 1 à 4, dans lequel l'enveloppe cylindrique électriquement conductrice ou semi-conductrice (1) ou le segment d'enveloppe comprend un élément flexible, en particulier un tube conducteur en silicone ou un patin en silicone couvert d'une encre ou d'un revêtement électriquement conducteur.

7. Capteur de tension capacitif (20), comprenant :
un condensateur (10) selon l'une des revendications 1 à 6 en tant que condensateur de détection de tension (CS) ;
une impédance de référence (CM) couplée en série entre le condensateur de détection de tension (CS) et un potentiel de référence (G) ; et
un circuit de mesure de tension configuré pour mesurer une chute de tension à travers l'impédance de référence (CM).

8. Procédé (M) de fabrication d'un condensateur (10) selon l'une quelconque des revendications 1 à 6, comprenant les étapes consistant à :
- appliquer (M1) un diélectrique (3) à un cylindre électriquement conducteur (2) ; et
- disposer (M2) une enveloppe cylindrique électriquement conductrice ou semi-conductrice (1), ou un segment d'enveloppe, de manière concentrique autour du cylindre électriquement conducteur (2) par-dessus le diélectrique (3),
dans lequel le diélectrique (3) comprend un composite particulaire incluant un matériau de matrice ayant un coefficient thermique de permittivité relative négatif et un matériau de charge particulaire mélangé au matériau de matrice, le matériau de charge particulaire ayant un coefficient thermique de permittivité relative positif, **caractérisé en ce que** le matériau de matrice comprend un matériau de caoutchouc, tel qu'un caoutchouc de silicone ou un élastomère de silicone et dans lequel le matériau de charge particulaire comprend un ou une combinaison d'un époxy, d'une résine polyuréthane, de fluorure de polyvinylidène et de copolymères de fluorure de polyvinylidène.

9. Procédé (M) selon la revendication 8, dans lequel l'application (M1) du diélectrique (3) comprend :
- le mélange (M1b) du matériau de charge particulaire à la composition de caoutchouc de silicone liquide ou d'élastomère de silicone dans un mélangeur statique ou dynamique d'une machine de moulage par injection ; et
- le moulage par injection (M1c) de la composition de silicone mélangée par-dessus le cylindre électriquement conducteur (2).

10. Procédé (M) selon la revendication 9, comprenant en outre :
le mélange (M1a) d'un matériau de charge particulaire supplémentaire avec la composition de caoutchouc de silicone liquide ou d'élastomère de silicone avant remplissage de la composition dans la machine de moulage par injection.
